(19) **Europäisches Patentamt / European Patent Office / Office européen des brevets**

(11) **EP 3 664 438 B1**

(12) **EUROPEAN PATENT SPECIFICATION**

(45) Date of publication and mention
of the grant of the patent:
**03.07.2024 Bulletin 2024/27**

(21) Application number: **18840307.5**

(22) Date of filing: **17.07.2018**

(51) International Patent Classification (IPC):
*H01L 27/146* (2006.01)   *H01L 31/10* (2006.01)
*G01S 17/36* (2006.01)   *G01S 7/4914* (2020.01)
*G01S 17/894* (2020.01)

(52) Cooperative Patent Classification (CPC):
**G01S 17/36; G01S 7/4914; G01S 17/894;
H01L 27/14609; H01L 27/1463; H01L 27/1464**

(86) International application number:
**PCT/JP2018/026711**

(87) International publication number:
**WO 2019/026606 (07.02.2019 Gazette 2019/06)**

(54) **IMAGING DEVICE**

**BILDGEBENDE VORRICHTUNG**

**DISPOSITIF D'IMAGERIE**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **01.08.2017   JP 2017149402**

(43) Date of publication of application:
**10.06.2020   Bulletin 2020/24**

(73) Proprietor: **Stanley Electric Co., Ltd.
Meguro-ku
Tokyo 153-8636 (JP)**

(72) Inventors:
• **NAKAZAWA, Katsunori
Tokyo 153-8636 (JP)**

• **GOTO, Hiroshige
Tokyo 153-8636 (JP)**

(74) Representative: **Emde, Eric
Wagner & Geyer Partnerschaft mbB
Patent- und Rechtsanwälte
Gewürzmühlstrasse 5
80538 München (DE)**

(56) References cited:
WO-A1-2007/026777    WO-A1-2007/026777
JP-A- 2000 312 024    JP-A- 2004 294 420
US-A1- 2013 113 969    US-A1- 2017 192 090

**Description**

Technical Field

The present invention relates to an imaging device which performs range finding using an image sensor.

Background Art

There are known imaging devices which employ TOF (Time of Flight) techniques to perform range finding using imaging sensors. In such an imaging device, modulated light is emitted in a shooting range to measure the time from when the modulated light is reflected on an object within the shooting range until the reflected light returns to each pixel on a pixel-by-pixel basis in order to measure the distance between each object within the shooting range and each pixel based on the measured time.

It is desired that the modulated light should be infrared light rather than visible light. This is because the modulated infrared light is easier to be distinguished from background visible light than the modulated visible light, and even if the modulated infrared light is irradiated to a person, it will not give the person unnecessary anxiety.

WO 2007/026777 A1 discloses an image sensor having a structure favorable for TOF range-finding using near-infrared light. The image sensor includes an epitaxial layer of an electric charge generation region, a surface buried region directly above (on the surface side of) the epitaxial layer, and an insulating film further on the surface side of the surface buried region. On the surface side of the insulating film, a light-receiving gate electrode at the center and first and second transfer gate electrodes on both sides are provided. When negative and positive voltages are applied to the first and second transfer gate electrodes, signal electric charges are transferred to an n-type first floating drain region. Further, when positive and negative voltages are applied to the first and second transfer gate electrodes, signal electric charges are transferred to the n-type second floating drain region. Since the signal electric charges are transferred from the surface to the first and second floating drain regions via the epitaxial layer located in a position deep from the surface, the annihilation of a signal electric charge by the near-infrared light during the transfer can be suppressed.

JP 2000-312024 A discloses a photoelectric conversion device which applies a reverse bias to a photodiode. In the photoelectric conversion device, an opening is formed in a central portion of an upper-layer semiconductor region of the two-layer semiconductor regions that constitute the photodiode. A central portion of a lower-layer semiconductor region is exposed from the opening, and wiring for the application of the reverse bias is connected to the exposed portion. The lower-side semiconductor region is fully depleted by the application of the reverse bias and the capacitance thereof is reduced.

Attention is also drawn to US 2013/113969 A1 and US 2017/192090 A1.

Summary of Invention

Technical Problem

Since infrared light is longer in wavelength than visible light, the position of occurrence of a photoelectric effect by the infrared light is a position deep from a light-receiving surface (surface on the light incident side of the image sensor). Since conventional imaging devices are often manufactured for visible light, the position of occurrence of the photoelectric effect of infrared light is limited to a region within the depletion layer of a photodiode and a region relatively close to an edge of the depletion layer even outside of the depletion layer. In this case, either one of positive and negative electric charges generated outside of the depletion layer enters the depletion layer by diffusion and then starts drifting by the electric field of the depletion layer. Since the diffusion rate is slow, the total transfer rate of an electric charge until reaching a corresponding semiconductor region becomes slow, causing a problem that the shutter speed (the number of range findings per unit time) becomes slow. Further, the slow diffusion rate increases the possibility that one electric charge will be recombined with the other electric charge, causing another problem that the amount of signal electric charge collection is reduced to decrease the sensitivity.

The imaging device of WO 2007/026777 A1 relates to an improvement in transferring a signal electric charge, generated and collected by the photoelectric effect, from the photodiode to an electric charge accumulating section, but does not relate to an improvement in the collection speed of the signal electric charge and the amount of signal electric charge collection in the photodiode before the accumulation of the signal electric charge.

Although the photoelectric conversion device of JP 2000-312024 A applies the reverse bias to the photodiode, a potential setting region is formed in the central portion of the upper-side semiconductor region to apply the reverse bias. Since the potential setting region does not usually contribute to photoelectric conversion, this leads to a decrease in light-receiving area. Further, when the lower-side semiconductor region is thick, since the reverse bias is not applied throughout the thickness of the lower-side semiconductor region, the depth of the depletion layer cannot be sufficiently increased.

It is an object of the present invention to provide an imaging device capable of efficiently collecting, in a semiconductor region, an electric charge generated by a photoelectric effect in a position deep from a light-receiving surface.

Solution to Problem

An imaging device of the present invention is provided as set forth in claim 1.

According to the present invention, the mutually different voltages are applied to the first potential setting region and the second potential setting region to generate, in the first semiconductor region, an accelerating electric field to accelerate either one of charges toward the second semiconductor region. This accelerating electric field can be generated over the entire thickness of the first semiconductor region even when the thickness of the first semiconductor region increases. Thus, a charge generated by a photoelectric effect in a position deep from a light-receiving surface can be collected in a corresponding semiconductor region efficiently.

Preferably, the imaging device of the present invention is such that the third semiconductor region is separated from the adjacent photodiode by the channel stopper, has a impurity concentration higher than each of the channel stopper and the first semiconductor region and is thinner than the second semiconductor region.

According to this configuration, a dark current and an afterimage can be suppressed efficiently by the third semiconductor region even if the accelerating electric field to accelerate either one of charges toward the second semiconductor region is generated in the first semiconductor region.

Preferably, the imaging device of the present invention is such that the image sensor has a light-receiving surface on a front side of the second semiconductor region.

As image sensors of imaging devices, there are two types, that is, an FSI (Front Side Illumination) type, in which the light incident side is the front side, and a BSI (Back Side Illumination) type in which the light incident side is the back side. According to this configuration, since the distance between the light-receiving surface and a depletion layer can be shortened by setting the front side of the second semiconductor region as the light-receiving surface, a charge generated in a position shallow from the light-receiving surface can be taken into the depletion layer properly.

Preferably, the imaging device of the present invention is such that the image sensor has a light-receiving surface on a back side of the first semiconductor region.

According to this configuration, since the distance between the light-receiving surface and the depletion layer can be lengthened by setting the back side of the second semiconductor region, light with a long wavelength can be selectively detected.

Preferably, the imaging device of the present invention is such that

the image sensor has a semiconductor substrate layer of the first conductive-type formed in common to the plurality of photodiodes,
the first semiconductor region is formed as an epitaxial layer on a front side of the semiconductor substrate layer,
the first potential setting region is the semiconductor substrate layer,
the second potential setting region is the channel stopper or the third semiconductor region, and
the controller applies mutually different voltages to the first potential setting region and the second potential setting region to generate the accelerating electric field.

According to this configuration, the FSI image sensor is such that the epitaxial layer as the first semiconductor region can be generated smoothly by providing the semiconductor substrate layer.

Preferably, the imaging device of the present invention is such that

the image sensor has a semiconductor substrate layer of the first conductive-type formed in common to the plurality of photodiodes,
the first semiconductor region is formed as an epitaxial layer on the front side of the semiconductor substrate layer,
the first potential setting region is a conductive-type transparent thin-film layer formed on the back side of the first semiconductor region,
the second potential setting region is the third semiconductor region, and
the controller applies mutually different voltages to the first potential setting region and the second potential setting region to generate the accelerating electric field.

According to this configuration, the BSI image sensor is such that a support substrate can be provided on the front side of the first semiconductor region, so that the imaging device can be highly reliable.

Preferably, the imaging device of the present invention is such that the epitaxial layer has a impurity concentration lower than the channel stopper to avoid overlapping of the depletion layers of adjacent photodiodes each other.

According to this configuration, power consumption due to the application of a reverse bias voltage can be suppressed while avoiding cross talk between adjacent pixels.

Preferably, the imaging device of the present invention is such that

the mutually different voltages supplied to the first potential setting region and the second potential setting region are such voltages that a distance between a light-receiving surface on the front side of the second semiconductor region and an edge of a depletion layer of the photodiode is longer than a wavelength of infrared light, and the impurity concentration of the epitaxial layer is set to such an impurity concentration as to avoid overlapping of the depletion layers of the adjacent photodiodes each other in the case where the mutually different voltages are being supplied to the first potential setting region and the second potential setting region.

According to this configuration, receiving of infrared light can be detected with high accuracy.

Preferably, the imaging device of the present invention is such that the first conductive-type and the second conductive-type are p-type and n-type, respectively. Brief Description of Drawings

FIG. 1 is an overall configuration diagram of an imaging device.
FIG. 2 is a configuration diagram of an image sensor provided in a camera.
FIG. 3 is a detailed configuration diagram of a pixel.
FIG. 4 is a timing chart of emitted modulated light and reflected modulated light.
FIG. 5A is a sectional view when subpixels of the image sensor are cut along a column direction of a pixel array section.
FIG. 5B is a sectional view when subpixels of an image sensor as a comparison example are cut along the column direction of a pixel array section.
FIG. 6A is a sectional view when the subpixels of the image sensor are cut along a row direction.
FIG. 6B is a sectional view when subpixels of an image sensor as another comparison example are cut along the row direction.
FIG. 7A is a sectional view of subpixels when a BSI-type image sensor is cut along a longitudinal direction.
FIG. 7B is a sectional view of subpixels when the BSI-type image sensor is cut along a transverse direction.

Description of Embodiment

(Entire Imaging Device)

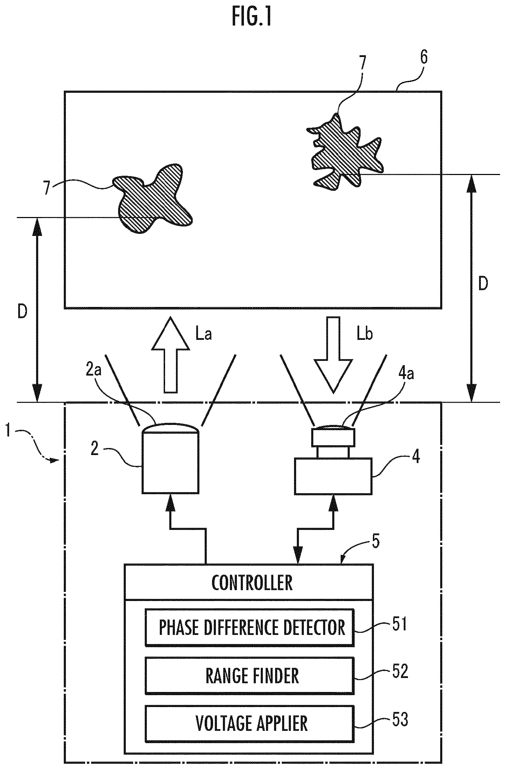

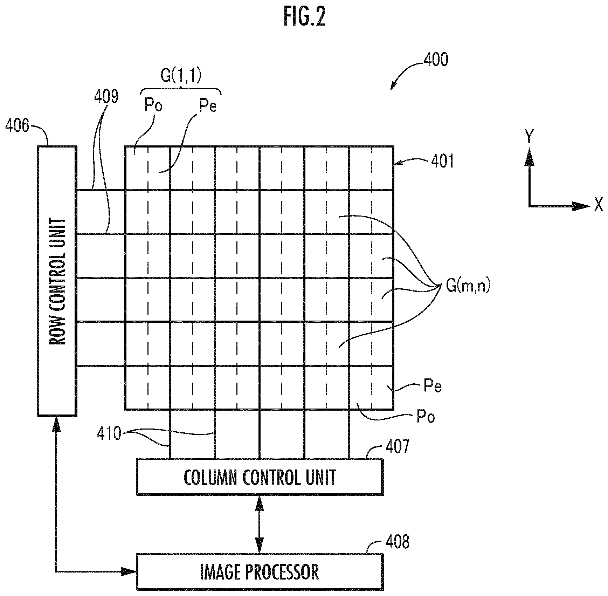

FIG. 1 is an overall configuration diagram of an imaging device 1. The imaging device 1 includes a modulated light emitting unit 2, a camera 4, and a controller 5 to measure distance D from the imaging device 1 to each range-finding target 7 existing within a shooting range 6 of the camera 4 for each pixel G (FIG. 2).

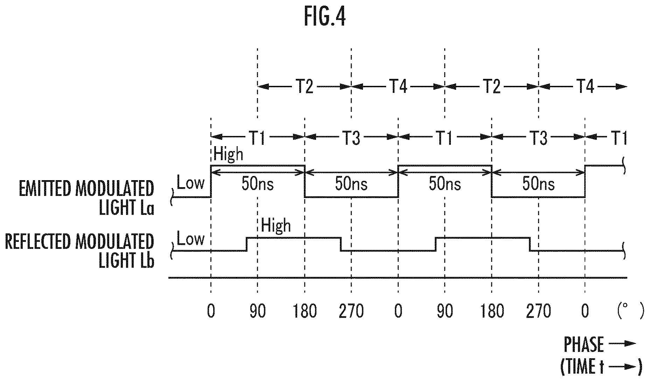

On and off of the modulated light emitting unit 2 is controlled by a control signal from the controller 5 to blink, for example, at 10 MHz (FIG. 4) so as to generate modulated light obtained by modulating the intensity of light. The distribution of the modulated light is adjusted by a lens 2a mounted in a light emitting section of the modulated light emitting unit 2 and emitted as emitted modulated light La. Thus, the emitted modulated light La is irradiated to the entire shooting range 6 at a time. As the emitted modulated light La, near-infrared light is used.

When one or more range-finding targets 7 exist within the shooting range 6, the emitted modulated light La is reflected on each range-finding target 7 to return to the imaging device 1 after being reflected as reflected modulated light Lb derived from the emitted modulated light La. A lens 4a is mounted in an incident section of the camera 4 to gather light incident from the shooting range 6 so as to enter an image sensor 400 (FIG. 2) inside the camera 4 as captured image light. The captured image light includes background light and reflected modulated light Lb. The reflected modulated light Lb enters corresponding pixels G (FIG. 2) on the image sensor 400 depending on the position occupied in the shooting range 6 by the range-finding target 7 from which the reflected modulated light Lb is derived.

The controller 5 includes a phase difference detector 51, a range finder 52, and a voltage applier 53.

The details of processing of the imaging device 1 to measure distance D to the range-finding target 7 by the TOF method will be described later. Here, the imaging device 1 will be schematically described. The image sensor 400 (FIG. 2) of the camera 4 makes it possible to externally read the amount of accumulated electric charge generated in relation to the intensity of incident light for each pixel. Note that there are two types of electric charges, i.e., holes as positive electric charges and electrons as negative electric charges. In the imaging device 1, the amount of electricity according to the number of electrons is accumulated as the amount of accumulated electric charge.

The phase difference detector 51 detects a phase difference $\varphi$ between the emitted modulated light La emitted by the modulated light emitting unit 2 and the reflected modulated light Lb based on the amount of accumulated electric charge read from the image sensor 400 for each pixel. The range finder 52 measures distance D based on the phase difference detected by the phase difference detector 51.

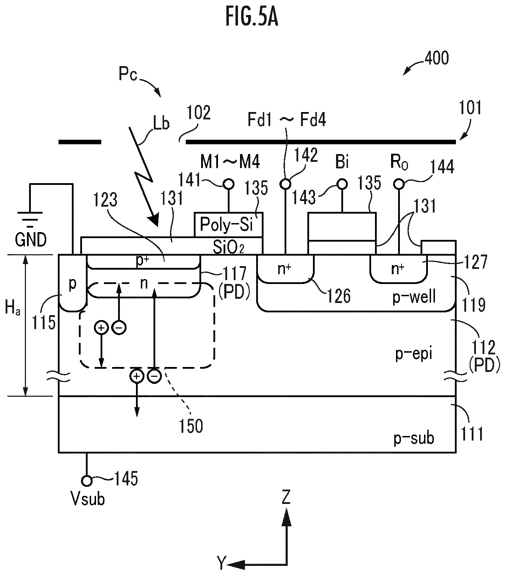

FIG. 2 is a configuration diagram of the image sensor 400 provided in the camera 4. Note that a three-axis orthogonal coordinate system is defined for convenience in describing the structure of a pixel array section 401 in FIG. 2 and subsequent figures, where the direction in which the light-receiving surface of the pixel array section 401 can be seen is set as a front view, and the row direction and the column direction of a lattice array of pixels G of the pixel array section 401 in the front view are set as the X axis direction and the Y axis direction, respectively. The positive direction of X axis is a direction from left to right in the front view of the pixel array section 401, and the positive direction of Y axis is a direction from down to up in the front view of the pixel array section 401. Z axis (in FIG. 5A, and the like) is a direction perpendicular to the light-receiving surface of the pixel array section 401, and the positive direction thereof is a direction from a side opposite to the side of the light-receiving surface of the pixel array section 401 to the light-receiving surface.

The image sensor 400 includes, as main components, the pixel array section 401, a row control unit 406, a column control unit 407, and an image processor 408. Note that this image sensor 400 is of a CMOS type.

The pixel array section 401 of FIG. 2 has a plurality of pixels G (m, n) distributed at a uniform density in the vertical (Y axis direction) and the horizontal (X axis direction) of the lattice array on the plane in the front view.

Note that each pixel G in the pixel array section 401 is expressed by the row number m and the column number n. It is assumed that pixel G (m, n) indicates the pixel G which is the m-th from up and the n-th from left in the front view of the pixel array section 401. The pixel array section 401 is, for example, composed of $126 \times 126$ pixels G. Hereinafter, pixel G (m, n) will be collectively called pixel G to omit (m, n) unless there is a need to particularly distinguish among individual pixels.

In the front view, each pixel G has a left subpixel Po (the suffix "o" means an odd number and the subpixel Po means that the column number is an odd number when the column numbers of a lattice array including the subpixels are defined) and a right subpixel Pe (the suffix "e" means an even number).

The row control unit 406 applies a control signal to each row control line 409 so that pixels G of the pixel array section 401 can be controlled row by row. The column control unit 407 applies a control signal to each column control line 410 so that pixels G of the pixel array section 401 can be controlled column by column. The image processor 408 controls the row control unit 406 and the column control unit 407 based on control signals (control voltages) from the controller 5 (FIG. 1).

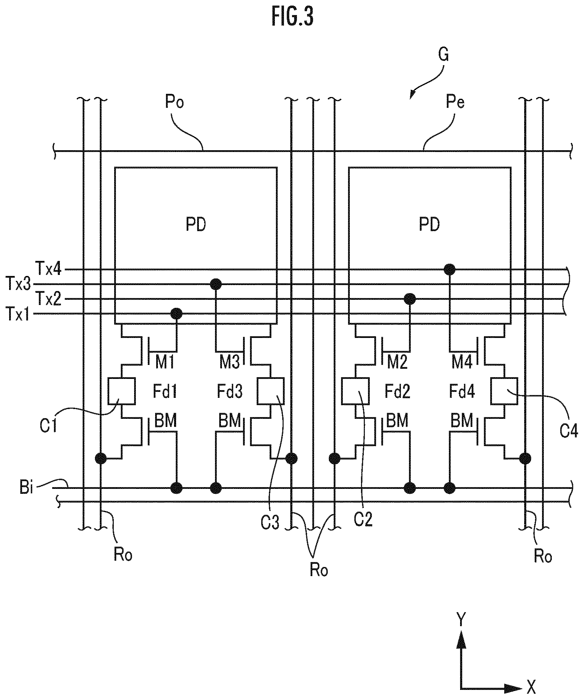

FIG. 3 is a detailed configuration diagram of each pixel G. The pixel G is composed of a pair of two subpixels, that is, the subpixel Po and the subpixel Pe.

The subpixel Po includes PD, M1, M3, Fd1, Fd3, and two BMs. The subpixel Pe includes PD, M2, M4, Fd2, Fd4, and two BMs. It is assumed that PD denotes a photodiode, M denotes a sorting switch, Fd denotes floating diffusion as an electric charge accumulating section, and BM denotes a transfer switch. M1 to M4 and BMs are FETs (field effect transistors).

Control signals to control on/off of M1 to M4 are supplied from the row control unit 406 to Tx1 to Tx4. A control signal to control on/off of BM is supplied from the row control unit 406 to Bi. A set of lines Tx1 to Tx4 and Bi is included in each row control line 409 (FIG. 2).

Ro is connected to the drains of all BMs in a corresponding column (in the corresponding column, respective lines of Fd1 to Fd4 are distinguished). The column control unit 407 reads, through Ro, C1 to C4 as read values for the amounts of electric charges accumulated in Fd1 to Fd4 of each pixel G. Ro is included in each column control line 410 (FIG. 2).

The subpixel Po and the subpixel Pe are the same in overall operation, except that the operation timings of M1 to M4 and BMs as gates inside the subpixels are only different. Therefore, only the operation of the subpixel Po will be described below.

The higher the intensity of incident light (including background light and reflected modulated light Lb) entering pixel G, the more electrons the PDs will generate. The amount of electric charge increases as the number of electrons increases. M1 and M3 are turned on and off in anti-phase by the applied voltages from Tx1 and Tx3. In other words, assuming that every on/off is set as one on/off cycle, the on period of M1 is the off period of M3, and the off period of M1 is the on period of M3 in each on/off cycle.

In the on period of M1, M3, electrons generated by PD are supplied to and accumulated in Fd1, Fd3. In Fd1, Fd3, an amount of electric charge related to the intensity of incident light entering the pixel G (strictly speaking, the subpixel Po or Pe) is accumulated. Ro becomes energized by turning on a switch in the column control unit 407 at predetermined read timing, and the amounts of electric charges in Fd1, Fd3 of the subpixel Po to which BMs in the on state belong at the time is read as read values C1, C3 by the image processor 408 through the column control unit 407. The read values C1, C3 are further sent from the image processor 408 to the controller 5 (FIG. 1).

FIG. 4 is a timing chart of emitted modulated light La and reflected modulated light Lb. The scale on the horizontal axis represents the value expressing the elapsed time as the phase of emitted modulated light La. The emitted modulated light La is light derived from laser light emitted from the modulated light emitting unit 2, and the level of the emitted modulated light La is Low when the modulated light emitting unit 2 is off, and High when the modulated light emitting unit 2 is on. The light intensity corresponding to the High level in the on state is increased or decreased by increase or decrease in supply current to the modulated light emitting unit 2.

The emitted modulated light La is light having a periodic pulse waveform, which is a rectangular wave with cycle = 100 ns (at frequency = 10 MHz) and duty ratio = 50%. In FIG. 4, the rise time of the emitted modulated light La is represented as phase = 0°. The reflected modulated light Lb is such that the emitted modulated light La emitted from the imaging device 1 reaches a range-finding target 7 (FIG. 1), is reflected on the range-finding target 7 and returned to the imaging device 1. As a result, the phase of the reflected modulated light Lb is delayed by the time of flight of a length twice the distance D to the range-finding target 7 from the emitted modulated light La to cause the phase difference φ between the emitted modulated light La and the reflected modulated light Lb. The distance D between the imaging device 1 and the range-finding target 7 can be measured by the phase difference φ.

As described above, the image processor 408 (FIG. 2) can read the amounts of electric charges in Fd1 to Fd4 of each pixel G through Bi and Ro. The image processor 408 can read the accumulated electric charges related to the incident intensity Ii of the reflected modulated light Lb incident on each pixel G from Fd1 to Fd4 of the pixel G. In FIG. 4, T1 to T4 indicate accumulation periods of the amounts of electric charges read by the image processor 408 from Fd1 to Fd4 in each pixel G, respectively.

The periods of T1 to T4 are different in start phase, but the lengths of the periods are set to be equal to 1/2 (= half cycle) of the cycle of the emitted modulated light La. T1 is set in a period of phases between 0° to 180°. T2 is set in a period of phases between 90° to 270°. T3 is set in a period of phases between 180° to 360°. T4 is set as a period of phases between 270° to 360° and a period of phases between 0° to 90° in the next cycle, that is, set as a period of phases between 270° to 450°. As a result, the amounts of electric charges corresponding to the incident intensity Ii of the reflected modulated light Lb incident on the corresponding subpixels during the periods of T1 to T4 are accumulated in Fd1 to Fd4. The image processor 408 reads, as read values, the amounts of electric charges accumulated in each pixel G during the periods of T1 to T4.

The controller 5 calculates the phase difference φ by Equation (1) below.

$$\text{Equation (1): Phase Difference } \varphi = \tan\text{-}1\{(C1\text{-}C3)/(C2\text{-}C4)\}$$

In the above equation, "tan" denotes the tangent, and "tan-1" denotes the arc tangent. Although the accumulated electric charge obtained by incident light derived from background light is included in each of C1 to C4, the influence of incident light derived from the background light is removed from a difference C1-C3 and a difference C2-C4.

(Semiconductor Structure of Image Sensor)

Referring to FIG. 5A to FIG. 6B, the structure of the image sensor 400 will be described. In order to make it easier to understand the structure of the image sensor 400, an image sensor 400b or an image sensor 400c as a comparison example is compared with the image sensor 400 in FIG. 5A to FIG. 6B. In the image sensor 400b, 400c as the comparison example, each element corresponding to each element of the image sensor 400 is given the same reference numeral as the element of the image sensor 400. Further, the term subpixel Pc is used as a general term for the subpixel Po, Pe.

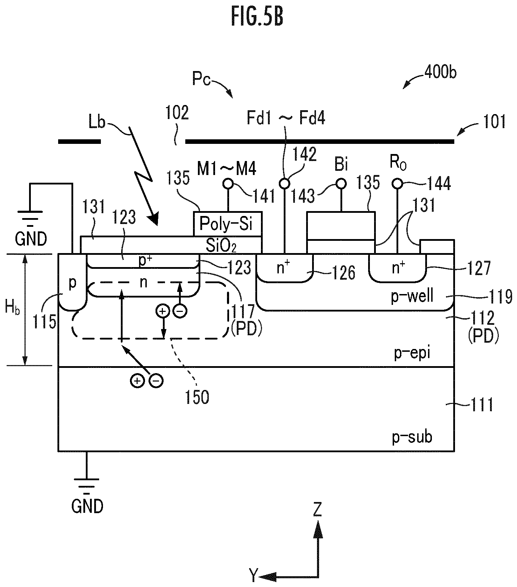

FIG. 5A and FIG. 5B are sectional views when the subpixel Pc is cut along the column direction (Y axis direction) of the pixel array section 401. FIG. 5A is a sectional view of the subpixel Pc of the image sensor 400, and FIG. 5B is a sectional view of a subpixel Pc of an image sensor 400b as a comparison example. The image sensor 400b is, for example, a conventional image sensor for visible light.

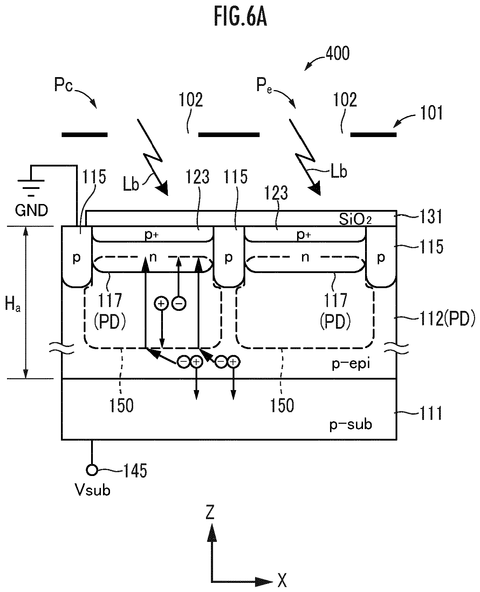

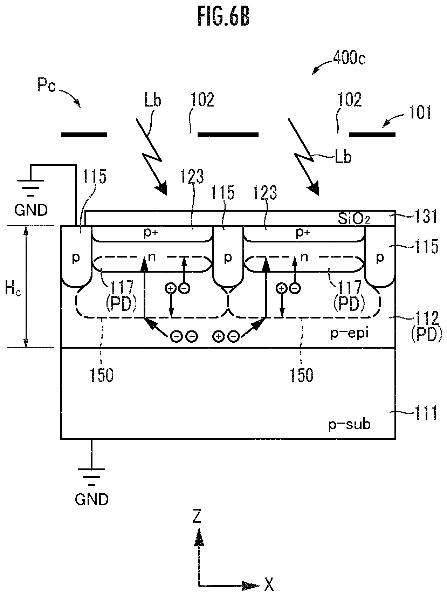

FIG. 6 contains sectional views when the subpixel Pc is cut along the row direction (X axis direction), where FIG. 6A is a sectional view of the subpixel Pc of the image sensor 400, and FIG. 6B is a sectional view of a subpixel Pc of an image sensor 400c as another comparison example. The image sensor 400c is, for example, an image sensor with the impurity concentration of p-epi (p-type epitaxial layer) 112 more decreased by a predetermined amount (made lower) than the image sensor 400b.

Although only one subpixel Pc is illustrated in FIG. 5 and FIG. 6, the same number of sectional structures in FIG. 5 and FIG. 6 as the total number of subpixels Pc in the column direction or the row direction are successive in the actual cross section of the pixel array section 401.

In semiconductor manufacturing, a new semiconductor region is formed by being laminated on a manufactured semiconductor region fabricated first. In this case, it is defined that the side of being laminated is the front side and the opposite side is the back side.

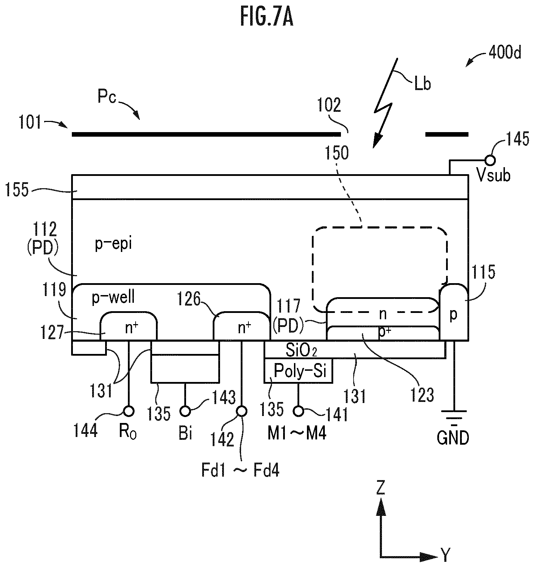

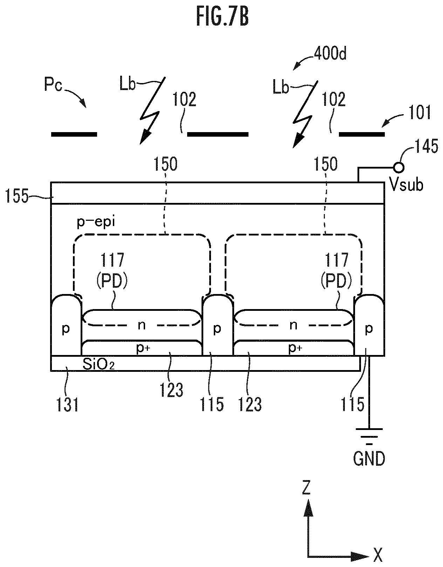

It is well known that there are two types of image sensors, that is, an FSI (Front Side Illumination) type and a BSI (Back Side Illumination) type. This image sensor 400 is of the FSI-type. In other words, it is set that the front side is the side of the light-receiving surface, and the back side is the side opposite to the side of the light-receiving surface. In contrast, in an image sensor 400d of the BSI-type in FIG. 7A and FIG. 7B to be described later, the front side is set as the side opposite to the side of the light-receiving surface, and the back side is set as the side of the light-receiving surface.

When the image sensor 400 is of the FSI-type, the size from the light-receiving surface to a depletion layer 150 (FIG. 5, and the like) in the Z axis direction can be made shorter than when the image sensor 400 is of the BSI-type. This is advantageous because electric charges generated by the photoelectric effect at a position close to the light-receiving surface (a shallow position) can be taken into the depletion layer 150.

In FIG. 5A and FIG. 6A, a light shield 101 is arranged with a predetermined space between the light shield 101 and the front side of the pixel array section 401 in the Z axis direction to cover the front side of the pixel array section 401 from the light incident side of the image sensor 400 (the positive side of the Z axis direction). The light shield 101 has a window 102 substantially equal in size to the light-receiving surface of PD in a portion to face PD (the same photodiode as PD in FIG. 2) of each subpixel Pc.

In the following description, a first conductive-type and a second conductive-type are set as p-type and n-type, respectively. The first conductive-type and the second conductive-type are defined to be conductive-types opposite to each other. In the present invention, the first conductive-type and the second conductive-type can also be set as n-type and p-type, respectively.

The image sensor 400 has p-sub (p-type semiconductor substrate layer) 111 and p-epi 112 formed on the front side of the p-sub. The thickness of the p-epi 112, i.e., the size in the Z axis direction is denoted by Ha.

In the p-epi 112, an n-type semiconductor region 117 and a p-well 119 are formed in different ranges of each subpixel Pc in such a manner as to be embedded from the front side. The range of the n-type semiconductor region 117 corresponds to a range occupied by PD in FIG. 3, and the range of the p-well 119 corresponds to a range occupied by Fd1, Fd3, and the like in FIG. 3 (when the subpixel Pc is the subpixel Po).

A p-type channel stopper 115 functions as separation between pixels or between PDs, which is formed in common to a plurality of PDs. The channel stopper 115 reaches a depth from the front side of the p-epi 112 to a side further below the back side of the n-type semiconductor region 117 (a negative side of the Z axis direction) to separate the n-type semiconductor region 117 and a p+ region 123 from an adjacent subpixel Pc. The channel stopper 115 is formed in the shape of a lattice to separate boundaries between subpixels Pc so as to surround each subpixel Pc in a rectangular frame in the front view of the pixel array section 401.

The p+ region 123 has a function to suppress a dark current and an afterimage. The impurity concentration of the p+ region 123 is higher than the impurity concentration of the p-sub 111 and the channel stopper 115 of the same conductive-type. Further, the thickness of the p+ region 123 (the size in the Z axis direction) is thinner than the thickness of the n-type semiconductor region 117.

An oxide film (silicon dioxide film) 131 is formed to cover the front side of the subpixel Pc except an n+ region 126 and an n+ region 127. A polysilicon film 135 is formed in a predetermined portion on the front side of the oxide film 131.

In FIG. 5, M1 to M4, Fd1 to Fd4, Bi, and Ro are as described with reference to FIG. 3. A connection point 141 is connected to any one of M1 to M4. A connection point 142 is connected to any one of Fd1 to Fd4. A connection point 143 is connected to Bi. A connection point 144 is connected to Ro.

The connection point 142 is connected to the n+ region 126. The connection point 144 is connected to the n+ region 127. A positive applied voltage to the connection point 141 is applied to the polysilicon film 135 connected to the connection point 141 to control an n channel between the n-type semiconductor region 117 and the n+ region 126. An applied voltage to the connection point 143 is applied to the polysilicon film 135 connected to the connection point 143 to control an n channel between the n+ region 126 and the n+ region 127.

The connection point 145 is connected to the back side of the p-sub 111, and supplied with Vsub as a negative voltage from the voltage applier 53 of the controller 5. The channel stopper 115 is supplied with GND (= 0 V) of 0 V from the voltage applier 53 of the controller 5. The potential of the n-type semiconductor region 117 is so set that the pn junction of the channel stopper 115 and the p+ region 123 will become a reverse bias state. The p-sub 111 is maintained at Vsub as a negative potential by the supply of Vsub from the connection point 145.

The p-epi 112 and the n-type semiconductor region 117 constitute one PD as a pair of anode and cathode, respectively, in each subpixel Pc. In a boundary area of the p-epi 112 and the n-type semiconductor region 117, the depletion layer 150 is formed. Since Vsub and GND as voltages different from each other are supplied to the connection point 145 and the channel stopper 115, the spread of the depletion layer varies to some degree.

Ha denotes the thickness of the p-epi 112 (the size in the Z axis direction). To cope with an increase in thickness of the depletion layer 150 by the application of reverse bias to PD, Ha is set to a value sufficiently larger than the thickness Hb of a p-epi 112 in the image sensor 400b where no reverse bias is applied to PD. As the absolute value of a negative voltage of Vsub increases, the end face of the back side of the depletion layer 150 approaches the end face of the front side of the p-sub 111 and eventually reaches the end face of the front side of the p-sub 111. The depletion layer 150 at this time is called a "fully depleted state." Even if the depletion layer 150 does not become the "fully depleted state," electrons generated over the entire area of the p-epi 112 by the accelerating electric field can be collected in the n-type semiconductor region 117.

Note that the upper limit of the absolute value of Vsub is set to such a value or less as not to cause a junction breakdown (dielectric breakdown) between the p-epi 112 and the n-type semiconductor region 117. For example, the minimum value of Vsub is generally -12 V (note: the larger the absolute value, the smaller the negative Vsub). Since the wavelength of infrared light is 830 to 960 nm, Vsub is so set that the depth from the light-receiving surface of PD to the bottom surface of the depletion layer 150 will be substantially equal to the wavelength of infrared light.

Only different points of the image sensor 400b from the image sensor 400 will be described with reference to FIG. 5B. The relation of the thickness Hb of the p-epi 112 with the thickness Ha of the p-epi 112 in the image sensor 400 is Hb < Ha. In the image sensor 400b, GND is supplied to both the p-sub 111 and the channel stopper 115 from the voltage applier 53 of the controller 5. Since no reverse bias is applied to PD in the image sensor 400b, the thickness of the depletion layer 150 is thinner than the thickness of the depletion layer 150 in the image sensor 400.

The image sensor 400 (FIG. 5A) and the image sensor 400b (FIG. 5B) are compared. When reflected modulated light Lb is infrared light, the wavelength of the reflected modulated light Lb is long. This makes easier that a photoelectric effect by the reflected modulated light Lb entering PD is produced in a position deep from the light-receiving surface of PD. In FIG. 5 and FIG. 6, + and - enclosed within circles indicate holes and electrons produced by the photoelectric effect, respectively. The holes and the electrons are produced in pairs. The photoelectric effects illustrated are all meant to be produced in positions deeper than the depletion layer 150.

When the position in which the photoelectric effect is generated is within the depletion layer 150, holes and electrons drift in the Z axis direction by the electric field inside the depletion layer 150 into the n-type semiconductor region 117 and the p-epi 112 outside of the depletion layer 150. Note that the drift speed is sufficiently faster than the diffusion rate. Further, when the position in which the photoelectric effect is generated is outside of the depletion layer 150, holes and electrons drift in the Z axis direction by the accelerating electric field into the n-type semiconductor region 117 and the p-epi 112 outside of the depletion layer 150.

In the image sensor 400, since the depletion layer 150 has a sufficient depth, the positions in which electrons are generated by the photoelectric effect can be within the depletion layer 150 even when the reflected modulated light Lb is infrared light.

Even when the position of occurrence of the photoelectric effect is further below the depletion layer 150 (the negative side of the Z axis direction) as illustrated, electrons (an example of either one of positive and negative electric charges) drift to reach the edge of the depletion layer 150 while being accelerated by the accelerating electric field, and after that, drift in the Z axis direction by the electric field inside the depletion layer 150 into the n-type semiconductor region 117 and the p-epi 112 outside of the depletion layer 150. Therefore, the electrons are recombined with holes and hence the possibility that the electrons are extinct is reduced so that the n-type semiconductor region 117 can collect sufficiently many electrons.

In contrast, in the image sensor 400b, the thickness of the depletion layer 150 is thin and no accelerating electric field exists in regions other than the depletion layer 150. As a result, when the reflected modulated light Lb is infrared light, many electrons by the photoelectric effect are generated in positions deeper than the depletion layer 150 to prolong the time required for the generated electrons to reach the n-type semiconductor region 117, and the number of electrons to reach the n-type semiconductor region 117 for recombination with the holes is reduced.

An image sensor 400c in FIG. 6B will be described. In the image sensor 400c, the depletion layer 150 is expanded by making the impurity concentration of the p-epi 112 lower than the impurity concentration of the p-epi 112 in the image sensor 400b. However, it is difficult to generate a directional electric field over the entire area of the depletion layer 150. Particularly, since the electric field inside the depletion layer 150 near the boundary of the depletion layer 150 is often insufficient to generate a drift, the depletion layer 150 is also expanded in the plane direction (X-axis and Y-axis directions) as well as in the depth direction.

This causes the depletion layers 150 in adjacent subpixels Pc to overlap each other in the plane direction. This is because electrons produced below the depletion layer 150 and near the boundary of adjacent depletion layers 150 are diffused in the depletion layer 150 of an adjacent subpixel Pc, rather than the subpixel Pc on which the reflected modulated light Lb as the cause of generation thereof is incident, to move into the n-type semiconductor region 117 of the adjacent subpixel Pc. This causes cross talk.

In contrast, in the image sensor 400, since a directional accelerating electric field also exists in the p-epi 112, which is not incorporated in the depletion layer, by the application of the reverse bias to PD as well as the depletion layer 150, cross talk can be prevented.

On the other hand, in the image sensor 400, a current flows by the application of voltages between the channel stopper 115 and the connection point 145, which may increase the current consumption of the image sensor 400. To cope with this, it is desired to reduce the impurity concentration of the p-epi 112 in order to increase the resistance of the p-epi 112.

As described above, the reduction in the impurity concentration of the p-epi 112 leads to the expansion of the depletion layer 150 in addition to the increase in the resistance of the p-epi 112. Therefore, there is a need to reduce the impurity concentration of the p-epi 112 enough to avoid cross talk, i.e., to such a degree that the depletion layers 150 of adjacent subpixels Pc will not overlap each other in the plane direction.

In the image sensor 400, the impurity concentration of the p-epi 112 is lower than the impurity concentration of the p-sub 111 and the channel stopper 115 of the same conductive-type. Further, the impurity concentration of the p-epi 112 in the image sensor 400 is lower than the impurity concentration of the p-epi 112 in the image sensor 400b. As an example, the impurity concentration of the p-epi 112 in the image sensor 400 is 1012 to 1013/cm3.

As measures to suppress the power consumption of the image sensor 400, there are the following methods in addition to reducing the impurity concentration of the p-epi 112 in the image sensor 400.

When the imaging device 1 is used for range-finding of a relatively short-range target 7, the intensity of the reflected modulated light Lb becomes sufficiently high. Therefore, even if the sensitivity of the imaging device 1 is reduced a little, the distance to the range-finding target 7 can be measured with the accuracy of an allowable value or more. Thus, when the imaging device 1 measures the distance to a relatively short-range target 7, the absolute value of the negative potential of Vsub is reduced accordingly to save power consumption.

When no range-finding target 7 exists in the shooting range 6, the imaging device 1 skips range-finding processing. When the range-finding processing is skipped, the voltage applier 53 does not supply Vsub to the connection point 145. Thus, the supply of Vsub is stopped when unnecessary to save the power consumption of the image sensor 400.

In the image sensor 400, the p-epi 112 corresponds to a first semiconductor region. The n-type semiconductor region 117 corresponds to a second semiconductor region. The p+ region 123 corresponds to a third semiconductor region. The p-sub 111 or the p-epi 112 corresponds to a first potential setting region. The channel stopper 115 or the n-type semiconductor region 117 corresponds to a second potential setting region.

As described above, the voltages are applied to the back side of the p-epi 112 (first semiconductor region) and the front side of the channel stopper 115 or the p+ region 123 to expand the thickness of the depletion layer 150. However, since it is not always necessary to realize the fully depleted state, the breakdown of PD can be sufficiently avoided. Further, since the voltages are applied to the back side of the p-epi 112 (first semiconductor region) and the front side of the channel stopper 115 or the p+ region 123 to generate the accelerating electric field over the entire area of the p-epi 112, cross talk caused by the fact that the electric field is weakened at the edge of the depletion layer can also be prevented.

FIGs 7A-7B relate to an example of application of the present invention to the BSI-type image sensor 400d, where FIG. 7A is a sectional view of the subpixel Pc cut along a longitudinal direction (Y axis direction), and FIG. 7B is a sectional view of the subpixel Pc cut along a transverse direction (X axis direction). In FIG. 7A and FIG. 7B, a support substrate (corresponding to the p-sub 111 in the FSI-type image sensor 400) is not illustrated.

In the subpixel Pc of the image sensor 400d, the same element as each element illustrated in the sectional view of the subpixel Pc of the FSI image sensor 400 of FIG. 5A and FIG. 6A is indicated by the same reference numeral as in FIG. 5A and FIG. 6A to omit the description thereof. Only points different in the structure of the image sensor 400d from that of the FSI image sensor 400 (FIG. 5A and FIG. 6A) will be described below.

In the BSI-type image sensor 400d, the back side of the p-epi 112 faces the e light shield 101. In this result, the back side of the p-epi 112 becomes the side of the light-receiving surface. Therefore, the channel stopper 115, the n-type semiconductor region 117, the p-well 119, the p+ region 123, the oxide film 131, and the like formed on the front side of the p-epi 112 are located on the opposite side of the light shield 101.

On the back side of the p-epi 112 (on the side of the light shield 101), a conductive-type transparent thin-film layer 155 is formed. Vsub supplied to the p-sub 111 in the FSI-type image sensor 400 is supplied to the conductive-type transparent thin-film layer 155 in the BSI-type image sensor 400d.

In the image sensor 400d, the p-epi 112 corresponds to the first semiconductor region. The n-type semiconductor region 117 corresponds to the second semiconductor region. The p+ region 123 corresponds to the third semiconductor region. The conductive-type transparent thin-film layer 155 corresponds to the first potential setting region. The channel stopper 115 or the n-type semiconductor region 117 corresponds to the second potential setting region.

In the image sensor 400d as BSI, the light shield (also called a "light shielding film") 101 is provided to avoid light color mixing. However, when there is no danger of color mixing, the light shield 101 can be omitted from the image sensor 400d.

(Variation)

In the embodiment, the p-epi 112, the n-type semiconductor region 117 and the p+ region 123 are examples of the first semiconductor region, the second semiconductor region, and the third semiconductor region of the present invention, respectively. The p-epi 112 and the channel stopper 115 are formed in common to a plurality of PDs. The n-type semiconductor region 117 and the p+ region 123 as components of each PD are formed in each subpixel Pc to be separated from each adjacent subpixel Pc (also as each adjacent PD).

The control signals to control on/off of M1 to M4 and the control signals to control on/off of BMs described with reference to FIG. 3 are examples of voltages supplied from a controller to an image sensor in the present invention.

Vsub and GND in FIG. 5 and FIG. 6 also correspond to voltages supplied from the controller to the image sensor in the present invention.

In the embodiment, the image sensor 400 in which each pixel G has two subpixels Pc is described. However, in the present invention, the image sensor may also be an image sensor in which each pixel G has no subpixel Pc, i.e., each pixel G is composed only of one pixel.

**Claims**

1. An imaging device (1) including an image sensor (400, 400d) having a plurality of photodiodes and a controller (5) which is adapted to control the image sensor (400, 400d), wherein

   each of the plurality of photodiodes includes:

   a first semiconductor region (112) of a first conductive-type formed in common to the plurality of photodiodes;
   a second semiconductor region (117) of a second conductive-type contrary to the first conductive-type, which is formed over the first semiconductor region (112) and is separated from an adjacent photodiode by a channel stopper (115) of the first conductive-type formed in common to the plurality of photodiodes;
   a third semiconductor region (123) of the first conductive-type formed over the second semiconductor region (117);
   a first potential setting region (111, 112, 155) which sets a potential in the first semiconductor region; and
   a second potential setting region (115, 117) which sets a potential in the third semiconductor region (123), and

   the controller (5) is adapted to supply mutually different voltages to the first potential setting region (111, 112, 155) and the second potential setting region (115, 117) to generate an accelerating electric field so as to acceleratedly move, into the second semiconductor region (117), either one of positive and negative electric charges generated in the first semiconductor region (112).

2. The imaging device according to claim 1, wherein
   the third semiconductor region (123) is separated from the adjacent photodiode by the channel stopper (115), has a impurity concentration higher than each of the channel stopper (115) and the first semiconductor region (112) and is thinner than the second semiconductor region (117).

3. The imaging device according to claim 1 or 2, wherein the image sensor (400) has a light-receiving surface on a front side of the second semiconductor region (117).

4. The imaging device according to claim 1 or 2, wherein the image sensor (400d) has a light-receiving surface on a back side of the first semiconductor region (112).

5. The imaging device according to claim 3, wherein

   the image sensor (400) has a semiconductor substrate layer (111) of the first conductive-type formed in common to the plurality of photodiodes,
   the first semiconductor region (112) is formed as an epitaxial layer on a front side of the semiconductor substrate layer (111),
   the first potential setting region is the semiconductor substrate layer (111),
   the second potential setting region is the channel stopper (115) or the third semiconductor region (123), and
   the controller (5) is adapted to apply mutually different voltages to the first potential setting region (111) and the second potential setting region (115, 123) to generate the accelerating electric field.

6. The imaging device according to claim 4, wherein

   the image sensor (400d) has a semiconductor substrate layer (111) of the first conductive-type formed in common to the plurality of photodiodes,
   the first semiconductor region (112) is formed as an epitaxial layer on the front side of the semiconductor substrate layer (111),
   the first potential setting region (155) is a conductive-type transparent thin-film layer formed on the back side of the first semiconductor region (112),

the second potential setting region (117) is the third semiconductor region, and
the controller (5) is adapted to apply mutually different voltages to the first potential setting region (155) and the second potential setting region (117) to generate the accelerating electric field.

7. The imaging device according to claim 5 or 6, wherein the epitaxial layer has a impurity concentration lower than the channel stopper (115) to avoid overlapping of the depletion layers of adjacent photodiodes each other.

8. The imaging device according to claim 5 or 6, wherein

the mutually different voltages supplied to the first potential setting region (111, 155) and the second potential setting region (115, 117, 123) are such voltages that a distance between a light-receiving surface on the front side of the second semiconductor region (117) and an edge of a depletion layer of the photodiode is longer than a wavelength of infrared light, and
the impurity concentration of the epitaxial layer is set to such an impurity concentration as to avoid overlapping of the depletion layers of the adjacent photodiodes each other in the case where the mutually different voltages are being supplied to the first potential setting region (111, 155) and the second potential setting region (115, 117, 123).

9. The imaging device according to any one of claims 1 to 8, wherein the first conductive-type and the second conductive-type are p-type and n-type, respectively.

**Patentansprüche**

1. Bildgebende Vorrichtung (1), die einen Bildsensor (400, 400d) mit einer Vielzahl von Fotodioden und eine Steuervorrichtung (5) aufweist, die ausgebildet ist, um den Bildsensor (400, 400d) zu steuern, wobei

jede der Vielzahl von Fotodioden Folgendes aufweist:

eine erste Halbleiterregion (112) eines ersten Leitfähigkeitstyps, die zusammen mit der Vielzahl von Fotodioden geformt ist;
eine zweite Halbleiterregion (117) eines zweiten Leitfähigkeitstyps, der entgegengesetzt zum ersten Leitfähigkeitstyp ist, die über der ersten Halbleiterregion (112) geformt ist und von einer benachbarten Fotodiode durch einen Kanalstopper (115) des ersten Leitfähigkeitstyps getrennt ist, die zusammen mit der Vielzahl von Fotodioden geformt ist;
eine dritte Halbleiterregion (123) des ersten Leitfähigkeitstyps, die über der zweiten Halbleiterregion (117) geformt ist;
eine erste Potentialeinstellungsregion (111, 112, 155), die ein Potential in der ersten Halbleiterregion einstellt; und
eine zweite Potentialeinstellungsregion (115, 117), die ein Potential in der dritten Halbleiterregion (123) einstellt, und

wobei die Steuervorrichtung (5) ausgebildet ist, um gegenseitig unterschiedliche Spannungen zu der ersten Potentialeinstellungsregion (111, 112, 155) und der zweiten Potentialeinstellungsregion (115, 117) zu liefern, um ein beschleunigendes elektrisches Feld zu erzeugen, um in beschleunigender Weise in die zweite Halbleiterregion (117) eine der positiven und negativen elektrischen Ladungen zu bewegen, die in der ersten Halbleiterregion (112) erzeugt wurden.

2. Bildgebende Vorrichtung nach Anspruch 1, wobei
die dritte Halbleiterregion (123) von der benachbarten Fotodiode durch den Kanalstopper (115) getrennt ist, eine Verunreinigungskonzentration hat, die höher ist als jene von sowohl dem Kanalstopper (115) als auch der ersten Halbleiterregion (112), und dünner ist als die zweite Halbleiterregion (117).

3. Bildgebende Vorrichtung nach Anspruch 1 oder 2, wobei der Bildsensor (400) eine Lichtaufnahmefläche an einer Vorderseite der zweiten Halbleiterregion (117) hat.

4. Bildgebende Vorrichtung nach Anspruch 1 oder 2, wobei der Bildsensor (400d) eine Lichtaufnahmefläche auf einer Rückseite der ersten Halbleiterregion (112) hat.

**5.** Bildgebende Vorrichtung nach Anspruch 3, wobei

der Bildsensor (400) eine Halbleitersubstratschicht (111) des ersten Leitfähigkeitstyps hat, die zusammen mit der Vielzahl von Fotodioden geformt ist,
die erste Halbleiterregion (112) als eine epitaxiale Schicht auf einer Vorderseite der Halbleitersubstratschicht (111) geformt ist,
die erste Potentialeinstellungsregion die Halbleitersubstratschicht (111) ist,
die zweite Potentialeinstellungsregion der Kanalstopper (115) oder die dritte Halbleiterregion (123) ist, und
wobei die Steuervorrichtung (5) ausgebildet ist, um gegenseitig unterschiedliche Spannungen an der ersten Potentialeinstellungsregion (111) und der zweiten Potentialeinstellungsregion (115, 123) anzulegen, um das beschleunigende elektrische Feld zu erzeugen.

**6.** Bildgebende Vorrichtung nach Anspruch 4, wobei

der Bildsensor (400d) eine Halbleitersubstratschicht (111) des ersten Leitfähigkeitstyps hat, die zusammen mit der Vielzahl von Fotodioden geformt ist,
die erste Halbleiterregion (112) als eine epitaxiale Schicht auf der Vorderseite der Halbleitersubstratschicht (111) geformt ist,
die erste Potentialeinstellungsregion (155) eine transparente Dünnfilmschicht eines leitfähigen Typs ist, die auf der Rückseite der ersten Halbleiterregion (112) geformt ist,
die zweite Potentialeinstellungsregion (117) die dritte Halbleiterregion ist und
wobei die Steuervorrichtung (5) ausgebildet ist, um gegenseitig unterschiedliche Spannungen an der ersten Potentialeinstellungsregion (155) und der zweiten Potentialeinstellungsregion (117) anzulegen, um das beschleunigende elektrische Feld zu erzeugen.

**7.** Bildgebende Vorrichtung nach Anspruch 5 oder 6, wobei die epitaxiale Schicht eine Verunreinigungskonzentration hat, die geringer ist als jene des Kanalstoppers (115), um ein Überlappen der Raumladungs- bzw. Verarmungsschichten von benachbarten Fotodioden miteinander zu vermeiden.

**8.** Bildgebende Vorrichtung nach Anspruch 5 oder 6, wobei

die gegenseitig unterschiedlichen Spannungen, die zu der ersten Potentialeinstellungsregion (111, 155) und der zweiten Potentialeinstellungsregion (115, 117, 123) geliefert werden, solche Spannungen sind, dass eine Distanz zwischen einer Lichtaufnahmefläche auf der Vorderseite der zweiten Halbleiterregion (117) und einer Kante einer Raumladungs- bzw. Verarmungsschicht der Fotodiode länger ist als eine Wellenlänge von infrarotem Licht, und
wobei die Verunreinigungskonzentration der epitaxialen Schicht auf eine derartige Verunreinigungskonzentration eingestellt ist, dass eine Überlappung der Raumladungs- bzw. Verarmungsschichten der benachbarten Fotodioden miteinander in dem Fall vermieden wird, wo die gegenseitig unterschiedlichen Spannungen zu der ersten Potentialeinstellungsregion (111, 155) und der zweiten Potentialeinstellungsregion (115, 117, 123) geliefert werden.

**9.** Bildgebende Vorrichtung nach einem der Ansprüche 1 bis 8, wobei der erste Leitfähigkeitstyp und der zweite Leitfähigkeitstyp in entsprechender Weise ein p-Typ und ein n-Typ sind.

**Revendications**

**1.** Dispositif d'imagerie (1) comportant un capteur d'image (400, 400d) ayant une pluralité de photodiodes et un contrôleur (5) qui est adapté pour commander le capteur d'image (400, 400d), dans lequel

chaque photodiode de la pluralité comporte :

une première région semiconductrice (112) d'un premier type de conductivité formé en commun avec la pluralité de photodiodes ;
une deuxième région semiconductrice (117) d'un deuxième type de conductivité opposé au premier type de conductivité, qui est formée sur la première région semiconductrice (112) et est séparée d'une photodiode adjacente par un arrêt de canal (115) du premier type de conductivité formé en commun avec la pluralité de photodiodes ;

une troisième région semiconductrice (123) du premier type de conductivité formée sur la première région semiconductrice (117) ;

une première région de réglage de potentiel (111, 112, 155) qui fixe un potentiel dans la première région semiconductrice ; et

une deuxième région de réglage de potentiel (115, 117) qui fixe un potentiel dans la troisième région semiconductrice (123), et

le contrôleur (5) est adapté pour fournir des tensions mutuellement différentes à la première région de réglage de potentiel (111, 112, 155) et à la deuxième région de réglage de potentiel (115, 117) pour générer un champ électrique accélérateur de façon à déplacer de façon accélérée, dans la deuxième région semiconductrice (117), l'une ou l'autre des charges électriques positives ou négatives générées dans la première région semiconductrice (112).

2. Dispositif d'imagerie selon la revendication 1, dans lequel
la troisième région semiconductrice (123) est séparée de la photodiode adjacente par l'arrêt de canal (115), a une concentration d'impuretés supérieure à celle de l'arrêt de canal (115) et à celle de la première région semiconductrice (112) et est plus fine que la deuxième région semiconductrice (117).

3. Dispositif d'imagerie selon la revendication 1 ou 2, dans lequel le capteur d'image (400) a une surface de réception de lumière sur une face avant de la deuxième région semiconductrice (117).

4. Dispositif d'imagerie selon la revendication 1 ou 2, dans lequel le capteur d'image (400d) a une surface de réception de lumière sur une face arrière de la première région semiconductrice (112).

5. Dispositif d'imagerie selon la revendication 3, dans lequel

le capteur d'image (400) a une couche de substrat semiconducteur (111) du premier type de conductivité formée en commun avec la pluralité de photodiodes,

la première région semiconductrice (112) est formée sous la forme d'une couche épitaxiale sur une face avant de la couche de substrat semiconducteur (111),

la première région de réglage de potentiel est la couche de substrat semiconducteur (111),

la deuxième région de réglage de potentiel est l'arrêt de canal (115) ou la troisième région semiconductrice (123), et

le contrôleur (5) est adapté pour appliquer des tensions mutuellement différentes à la première région de réglage de potentiel (111) et à la deuxième région de réglage de potentiel (115, 123) pour générer le champ électrique accélérateur.

6. Dispositif d'imagerie selon la revendication 4, dans lequel

le capteur d'image (400d) a une couche de substrat semiconducteur (111) du premier type de conductivité formée en commun avec la pluralité de photodiodes,

la première région semiconductrice (112) est formée sous la forme d'une couche épitaxiale sur la face avant de la couche de substrat semiconducteur (111),

la première région de réglage de potentiel (155) est une couche mince transparente de type de conductivité formée sur la face arrière de la première région semiconductrice (112),

la deuxième région de réglage de potentiel (117) est la troisième région semiconductrice, et

le contrôleur (5) est adapté pour appliquer des tensions mutuellement différentes à la première région de réglage de potentiel (155) et à la deuxième région de réglage de potentiel (117) pour générer le champ électrique accélérateur.

7. Dispositif d'imagerie selon la revendication 5 ou 6, dans lequel la couche épitaxiale a une concentration d'impuretés inférieure à celle de l'arrêt de canal (115) pour éviter le chevauchement des couches d'appauvrissement des photodiodes adjacentes les unes des autres.

8. Dispositif d'imagerie selon la revendication 5 ou 6, dans lequel

les tensions mutuellement différentes fournies à la première région de réglage de potentiel (111, 155) et à la deuxième région de réglage de potentiel (115, 117, 123) sont des tensions telles qu'une distance entre une surface de réception de lumière sur la face avant de la deuxième région semiconductrice (117) et un bord d'une couche d'appauvrissement de la photodiode est plus long qu'une longueur d'onde de lumière infrarouge, et la concentration d'impuretés de la couche épitaxiale est réglée à une concentration d'impuretés telle qu'elle empêche le chevauchement des couches d'appauvrissement des photodiodes adjacentes les unes des autres dans le cas où les tensions mutuellement différentes sont fournies à la première région de réglage de potentiel (111, 155) et à la deuxième région de réglage de potentiel (115, 117, 123).

9. Dispositif d'imagerie selon l'une quelconque des revendications 1 à 8, dans lequel le premier type de conductivité et le deuxième type de conductivité sont respectivement le type p et le type n.

# FIG.1

# FIG.2

## FIG.3

# FIG.4

## FIG.5A

# FIG.5B

# FIG.6A

# FIG.6B

## FIG.7A

# FIG.7B

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007026777 A1
- JP 2000312024 A
- US 2013113969 A1
- US 2017192090 A1